# EUROPEAN PATENT APPLICATION

(11) **EP 3 879 286 A1**
(43) Date of publication of application: **15.09.2021**
(21) Application number: 20161987.1
(22) Date of filing: 10.03.2020
(51) Int. Cl.: G01R 31/28, G01R 27/06, G01R 27/32

(54) **SEMICONDUCTOR DIE AND METHOD FOR TESTING AN ELECTRONIC CIRCUIT FORMED IN A SEMICONDUCTOR DIE**

(71) Applicant: Infineon Technologies AG, 85579 Neubiberg (DE)
(72) Inventor: Engelsberger, Franz Xaver, 83075 Bad Feilnbach (DE); Wojnowski, Maciej, 81735 München (DE)
(74) Representative: 2SPL Patentanwälte PartG mbB

(57) **Abstract**

A semiconductor die is provided. The semiconductor die includes a contact element for coupling the semiconductor die to the exterior. The contact element is coupled to an electronic circuit formed in the semiconductor die. Further, the semiconductor die includes a capacitive element for providing a compensation capacitance. The capacitive element is coupled between the contact element and the electronic circuit. The capacitive element and the contact element are electrically coupled via an inductive element in order to form a compensation network for compensating radio frequency parasitics.

## Description

### Field

The present disclosure relates to interfacing between semiconductor dies and the exterior. In particular, examples relate to a semiconductor die and a method for testing an electronic circuit formed in a semiconductor die.

### Background

Conventionally, die pads provide a physical interface between circuitry in a semiconductor chip and external connections such as bond wires, solder bumps or package redistribution layers. A die pad introduces a significant capacitance which promotes the generation of Radio Frequency (RF) parasitics at the die pad. RF parasitics may, e.g., disturb RF probing during on-wafer characterization of the semiconductor chip.

### Summary

Hence, there may be a demand for improved interfacing between a semiconductor die and the exterior.

The demand may be satisfied by the subject matter of the appended claims.

An example relates to a semiconductor die. The semiconductor die comprises a contact element for coupling the semiconductor die to the exterior. The contact element is coupled to an electronic circuit formed in the semiconductor die. Further, the semiconductor die comprises a capacitive element for providing a compensation capacitance. The capacitive element is coupled between the contact element and the electronic circuit. The capacitive element and the contact element are electrically coupled via an inductive element in order to form a compensation network for compensating RF parasitics.

Another example relates to a method for testing an electronic circuit formed in a semiconductor die. The method comprises placing a RF probe onto a contact element of the semiconductor die for coupling the semiconductor die to the exterior. The contact element is coupled to the electronic circuit. A capacitive element for providing a compensation capacitance is formed in the semiconductor die. The capacitive element is coupled between the contact element and the electronic circuit. The capacitive element and the contact element are electrically coupled via an inductive element in order to form a compensation network for compensating RF parasitics. The method further comprises applying a test signal to the contact element via the RF probe.

### Brief description of the Figures

Some examples of apparatuses and/or methods will be described in the following by way of example only, and with reference to the accompanying figures, in which
Fig. 1 illustrates a first example of a semiconductor die;
Figs. 2 and 3 illustrate exemplary equivalent circuits for the example illustrated in Fig. 1;
Figs. 4 to 6 illustrates various examples for implementing the capacitive element;
Figs. 7a and 7b illustrate exemplary transmission and reflection performances;
Fig. 8 illustrates a second example of a semiconductor die;
Figs. 9 and 10 illustrate exemplary equivalent circuits for the example illustrated in Fig. 8;
Figs. 11a and 11b illustrate exemplary transmission and reflection performances; and
Fig. 12 illustrates a flowchart of an example of a method for testing an electronic circuit formed in a semiconductor die.

### Detailed Description

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described. Further examples may cover all modifications, equivalents, and alternatives falling within the scope of the disclosure. Same or like numbers refer to like or similar elements throughout the description of the figures, which may be implemented identically or in modified form when compared to one another while providing for the same or a similar functionality.

It will be understood that when an element is referred to as being "connected" or "coupled" to another element, the elements may be directly connected or coupled via one or more intervening elements. If two elements A and B are combined using an "or", this is to be understood to disclose all possible combinations, i.e. only A, only B as well as A and B, if not explicitly or implicitly defined otherwise. An alternative wording for the same combinations is "at least one of A and B" or "A and/or B". The same applies, mutatis mutandis, for combinations of more than two Elements.

The terminology used herein for the purpose of describing particular examples is not intended to be limiting for further examples. Whenever a singular form such as "a", "an" and "the" is used and using only a single element is neither explicitly nor implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises", "comprising", "includes" and/or "including", when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong.

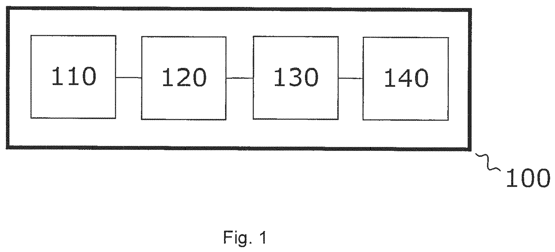

**Fig. 1** illustrates an example of a semiconductor die 100. The semiconductor die 100 is made up of semiconductor material such as, e.g., silicon or gallium arsenide. The semiconductor die 100 may optionally comprise further materials (e.g. metal material, isolating material, ...). The semiconductor die 100 may comprise one or more layers of material.

An electronic circuit 140 is formed in the semiconductor die 100. The electronic circuit 140 may be any type of electronic circuit that can be formed in semiconductor material. For example, the electronic circuit 140 may comprise one or more elements such as transistors, resistors, capacitors or diodes.

The semiconductor die 100 further comprises a contact element 110 for coupling (connecting) the semiconductor die 100 to the exterior (i.e. any device or element external to the semiconductor die 100). For example, the contact element 110 may be for coupling the semiconductor die 100 to a bond wire, a solder bump, a package redistribution layer or any other element of a semiconductor package. The contact element 100 is coupled (connected) to the electronic circuit 140. The contact element 110 may, e.g., be formed on a surface of the semiconductor die 100. For example, the contact element 110 may be a contact pad (die pad) formed on the surface of the semiconductor die 100. Alternatively, the contact element 110 may be formed within the semiconductor die 100. For example, the contact element 110 may covered by one or more layers of the semiconductor die 100 and only be accessible (reachable) via one or more openings in the one or more layers covering it.

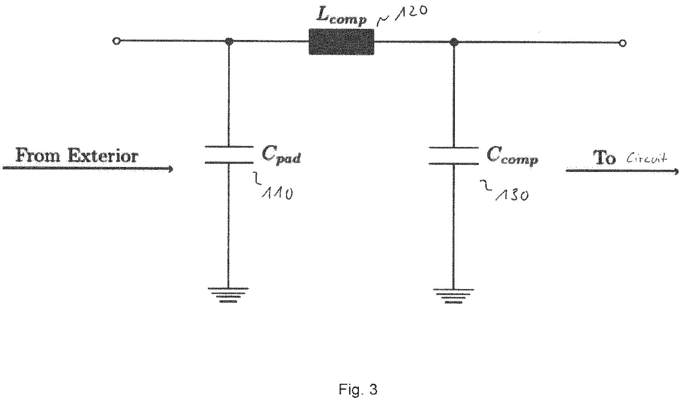

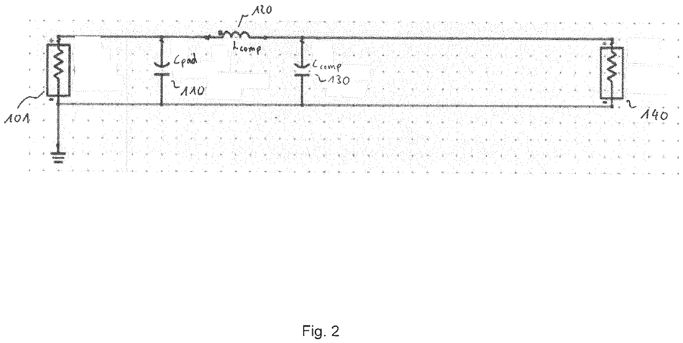

The contact element 110 exhibits an inherent capacitance C_{pad} as can be seen in the equivalent circuit diagrams illustrated in **Fig. 2** and **Fig. 3****.** Due to the inherent capacitance C_{pad} of the contact element 110, RF parasitics may be generated when an RF signal is applied to the contact element 110 from an exterior device or element 101 (e.g. an RF probe used for RF probing of the semiconductor die 100).

In order to overcome the RF parasitics, the semiconductor die 100 additionally comprises a dedicated capacitive element 130 for providing a compensation capacitance C_{comp}. The capacitive element 130 is coupled (connected) between the contact element 110 and the electronic circuit 140. Further, the capacitive element 130 and the contact element 110 are electrically coupled (connected) via an inductive element 120 exhibiting an (compensation) inductance L_{comp} in order to form a compensation network for compensating the RF parasitics in one or more desired frequency ranges. In other words, the inherent capacitance C_{pad} of the contact element 110 may be compensated at least in part by means of an LC compensation network formed by the inductive element 120 and the capacitive element 130.

Compensating the inherent capacitance C_{pad} of the contact element 110 by means of an LC compensation network may be advantageous for multiple reasons. For example, using the LC compensation network may enable transmission of DC signals (low frequency signals) from the exterior device or element 101 into the semiconductor die 100 (e.g. to the electronic circuit 140). For example, a DC signal may be used for supplying an amplifier circuit or an electronic calibration circuit of the electronic circuit 140 with power, or for selecting an operation mode of the electronic circuit 140. The LC compensation network may allow for a significantly increased bandwidth of the contact element 110 compared to conventional semiconductor dies.

The capacitive element 130 may be formed (exclusively) on the surface of the semiconductor die 100 or may be formed (exclusively) within the semiconductor die 100. In some examples, capacitive element 130 may be formed in part within the semiconductor die 100 and in part on the surface of the semiconductor die 100. The capacitive element 130 may be a single element or may comprise more than one capacitive sub-element. In other words, a plurality of capacitive sub-elements may form the capacitive element 130. The capacitive element 130 may be a multilayer element formed in multiple layers of the semiconductor die 100.

Similarly, the inductive element 120 may be formed (exclusively) on the surface of the semiconductor die 100 or may be formed (exclusively) within the semiconductor die 100. In some examples, inductive element 120 may be formed in part within the semiconductor die 100 and in part on the surface of the semiconductor die 100. The inductive element 120 may be a single element or may comprise more than one inductive sub-element. In other words, a plurality of inductive sub-elements may form the inductive element 120. The inductive element 120 may be a multilayer element formed in multiple layers of the semiconductor die 100. For example, the inductive element 120 may be a signal line (e.g. a copper line) coupling the capacitive element 130 and the contact element 110.

The capacitive element 130 and the inductive element 120 may at least in part be formed in the same layer(s) of the semiconductor die 100. For example, the capacitive element 130 and the inductive element 120 may be formed in exactly the same layer(s) of the semiconductor die 100. In other examples, the capacitive element 130 may be formed in or more first layers of the semiconductor die 100, whereas the inductive element 120 may be formed in or more different second layers of the semiconductor die 100 (at least one of the first layers of the semiconductor die 100 is different from the second layers of the semiconductor die 100). In still other examples, the capacitive element 130 and/or the inductive element 120 may both be formed (exclusively) on the surface of the semiconductor die 100.

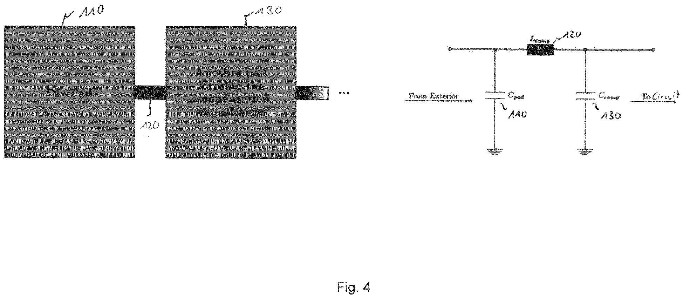

In the following, three examples for implementing the capacitive element 130 will be described with reference to Figs. 4 to 6.

**Fig. 4** illustrates in the left part a first example, in which the capacitive element 130 is a pad of electrically conductive material. For example, the pad of electrically conductive material may have identical or similar geometric dimensions as the contact element 110. In other examples, the pad of electrically conductive material may have different geometric dimensions as the contact element 110. The geometric dimensions of the pad of electrically conductive material may be selected based on a desired (target) capacitance of the capacitive element 130. The pad of electrically conductive material may be formed on the surface of the semiconductor die 100 (e.g. together with the contact element 110) or be formed within the semiconductor die 100 (e.g. in a same or a different layer than the contact element 110). The pad of electrically conductive material and the contact element 110 may be made up of the same or different materials. Although the capacitive element 130 is illustrated in Fig. 4 as a single pad of electrically conductive material, it may alternatively be formed by two or more pads of electrically conductive material.

In the example of Fig. 4, the inductive element 120 is formed by a conductive structure serving as a signal line. For example, the length of the inductive element 120 may be selected based on a target (desired) inductance of the inductive element 120 (e.g. a length of 100 µm for obtaining an inductance of 100 pH).

For reasons of simplicity, the electronic circuit formed in the semiconductor device 100 is not illustrated in Fig. 4.

An equivalent circuit of the above described arrangement is illustrated in the right part of Fig. 4. The equivalent circuit is identical to the one illustrated in Fig. 3.

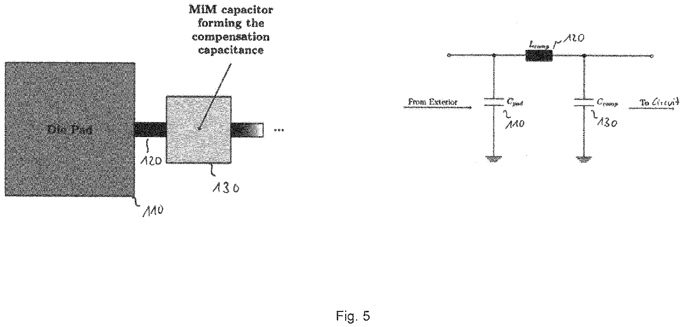

**Fig. 5** illustrates in the left part a second example, in which the capacitive element 130 is Metal-insulator-Metal (MiM) capacitor. Other than that, the example of Fig. 5 is identical to the example of Fig. 4. Compared to a pad of electrically conductive material, a MiM capacitor shows an improved area consumption. In other words, a MiM capacitor consumes less area than a pad of electrically conductive material for providing a desired (target) capacitance. Although the capacitive element 130 is illustrated in Fig. 5 as a single MiM capacitor, it may alternatively be formed by two or more MiM capacitors. Like in Fig. 4, an equivalent circuit is illustrated in the right part of Fig. 5.

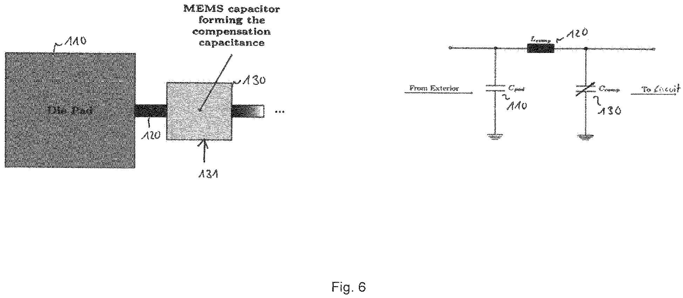

In a third example is illustrated in the left part of **Fig. 6****,** the capacitive element 130 is a MEMS capacitor. A MEMS capacitor is a capacitor manufactured in MicroElectroMechanical Systems (MEMS) technology. A distance (gap) between electrodes of the MEMS capacitor is adjustable based on one or more control signals 131 (e.g. the number of control signal may depend on the implementation of the MEMS capacitor) for adjusting a capacitance of the MEMS capacitor (e.g. to the target/desired compensation capacitance C_{comp}). In other words, the MEMS capacitor is configured to receive one or more control signals 131 for adjusting an adjustable capacitance of the MEMS capacitor (e.g. the MEMS capacitance may be adjusted via DC biasing). Other than that, the example of Fig. 6 is identical to the examples of Figs. 4 and 5. Like in Fig. 4 or Fig. 5, an equivalent circuit is illustrated in the right part of Fig. 6.

The adjustable compensation capacitance C_{comp} of the MEMS capacitor may allow to fine tune (adjust) the target frequency range to be filtered.

Although the capacitive element 130 is illustrated in Fig. 6 as a single MEMS capacitor, it may alternatively be formed by two or more MEMS capacitor.

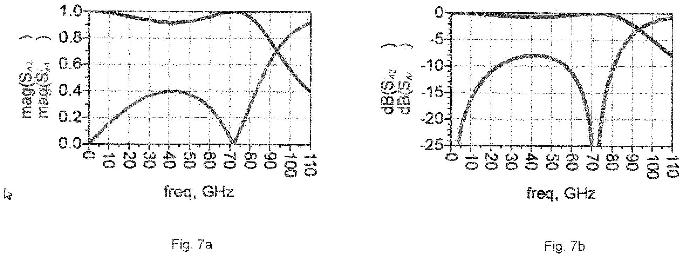

In the following, the performance of the proposed interface technique will be described with reference to Figs. 7a and 7b. **Fig. 7a** illustrates an exemplary magnitude plot of the reflection loss and the insertion loss when using the proposed LC compensation network. **Fig. 7b** illustrates an equivalent dB scaled plot.

The reflection loss is indicated by the scattering parameter S₁₁. The insertion loss is indicated by the scattering parameter S₁₂.

In the example of Figs. 7a and 7b, the compensation capacitance C_{comp} of the capacitive element 130 and the inductance L_{comp} of the inductive element 120 are selected such that the interface of the semiconductor die 100 is substantially transparent for RF signals at about 72 GHz. As can be seen from Fig. 7b, the insertion loss is lower than 0.001 dB at 72 GHz. That is, the RF parasitics are effectively compensated at about 72 GHz. Further, as can be seen from Figs. 7a and 7b, there is no short circuit at DC (i.e. around 0 GHz) since the proposed LC compensation network avoids a galvanic coupling to ground.

The proposed semiconductor die interface allows to compensate RF parasitics at substantially any target (desired) frequency range by simply tuning the values of the compensation capacitance C_{comp} of the capacitive element 130 and/or the inductance L_{comp} of the inductive element. In other words, the capacitance C_{comp} of the capacitive element 130 and the inductance L_{comp} of the inductive element 120 may be selected based on one or more target frequency ranges for compensating the RF parasitics.

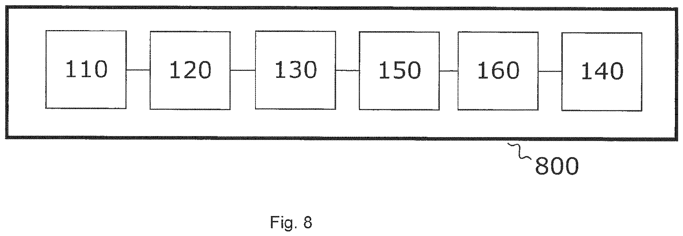

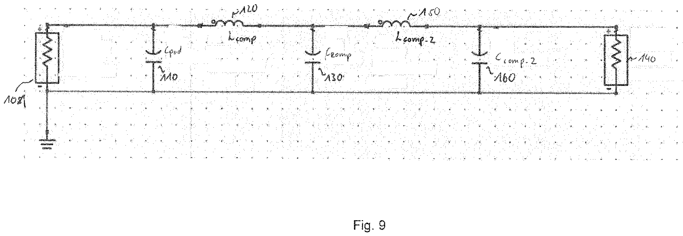

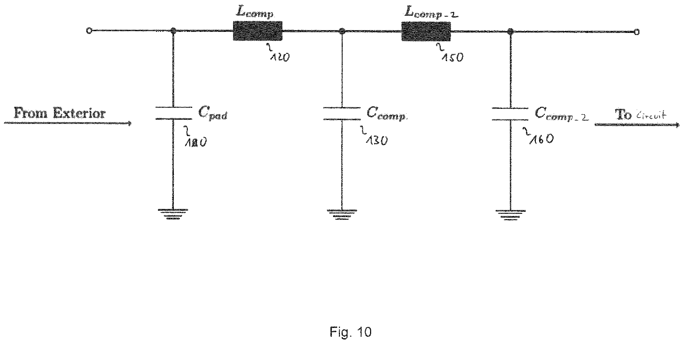

In order to enable compensation of RF parasitics at one or more further target frequency ranges, additional capacitive and inductive elements may be used. An exemplary semiconductor die 800 is illustrated in **Fig. 8****.** Equivalent circuit diagrams for the semiconductor die 800 are illustrated in **Fig. 9** and **Fig. 10****.**

In comparison to the semiconductor die 100 is illustrated in Fig. 1, the semiconductor die 800 additionally comprises a second capacitive element 160 for providing a second compensation capacitance C_{comp_2}. The second capacitive element 160 is coupled between the (first) capacitive element 130 and the electronic circuit 140. The second capacitive element 160 is electrically coupled to the capacitive element 130 and the contact element 110 via a second inductive element 150 (exhibiting a second inductance L_{comp_2}) to form the compensation network. The (first) capacitive element 130 and the (first) inductive element 120 form a first section of the compensation network, whereas the second capacitive element 160 and the second inductive element 150 form a second section of the compensation network. The second capacitive element 160 and the second inductive element 150 may be implemented as described above for the capacitive element 130 and the inductive element 120.

In the example of Figs. 8 to 10, the compensation network comprises two sections. For example, the first section of the compensation network may be for compensating the RF parasitics in a first target frequency range, whereas the second section of the compensation network may be for compensating the RF parasitics in a second target frequency range (e.g. different from the first target frequency range). In order to cover different target frequency ranges, the capacitive element 130 and the second capacitive element 160 may exhibit different capacitances and/or the inductive element 120 and the second inductive element 150 may exhibit different inductances.

It is to be noted that the proposed technology is not limited to using two sections for compensating RF parasitics in different frequency ranges. In general, any number of sections may be used. Using a multi-section LC compensation network may allow to further enhance the performance of the semiconductor die interface since each additional section may enable an additional frequency operation range. Compared to a single section LC compensation network, a multi-section LC network may further allow to increase the maximum operating frequency of the semiconductor die interface.

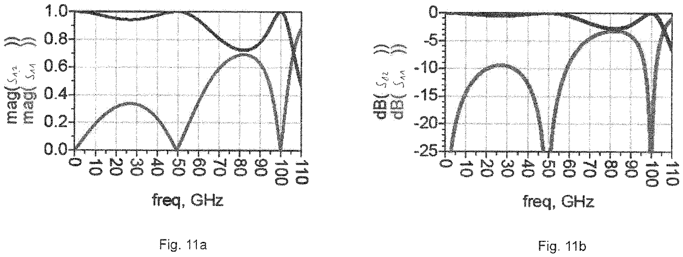

The performance of the interface described above in connection with Figs. 8 to 10 is shown in Figs. 11a and 11b. **Fig. 11a** illustrates an exemplary magnitude plot of the reflection loss and the insertion loss when using the proposed LC compensation network. **Fig. 11b** illustrates an equivalent dB scaled plot. The reflection loss is again indicated by the scattering parameter S₁₁ and the insertion loss by the scattering parameter S₁₂.

In the example of Figs. 11a and 11b, the compensation capacitance C_{comp} of the capacitive element 130 and the inductance L_{comp} of the inductive element 120 are selected such that the interface of the semiconductor die 100 is substantially transparent for RF signals at about 50 GHz. The compensation capacitance C_{comp_2} of the second capacitive element 160 and the inductance L_{comp_2} of the second inductive element 150 are further selected such that the interface of the semiconductor die 100 is substantially transparent for RF signals at about 100 GHz.

As can be seen from Fig. 11b, the interface shows good performance in terms of insertion loss around 50 GHz (better than 0.001 dB at 49.40 GHz) and around 100 GHz (better than 0.001 dB at 99.85 GHz). The good performance around 50 GHz is due to the first section of the LC compensation network (formed by the capacitive element 130 and the inductive element 120), while the good performance around 100 GHz is due to the second section of the LC compensation network (formed by the second capacitive element 160 and the second inductive element 150). Further, as can be seen from Figs. 11a and 11b, there is again no short circuit at DC (i.e. around 0 GHz) since the proposed LC compensation network avoids a galvanic coupling to ground.

As described above, by adding additional sections to the LC compensation network, RF parasitics may be compensated in further target frequency ranges and enable good performance of the semiconductor die interface at even higher frequencies.

The symmetric design of the multi-section LC compensation network in Figs. 8 to 10 is merely chosen for demonstration purposes but is not necessarily required.

A semiconductor die comprising an interface according to the proposed technology may, e.g., allow broadband RF measurement/characterization of the semiconductor die with high performance.

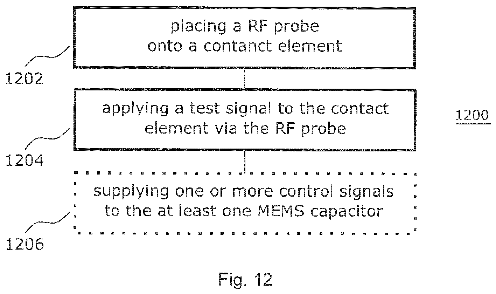

An example of a method 1200 for testing an electronic circuit formed in a semiconductor die according to the proposed technique is further illustrated in **Fig. 12****.** The method 1200 comprises placing 1202 a RF probe onto a contact element of the semiconductor die for coupling the semiconductor die to the exterior. As described above, the contact element is coupled to the electronic circuit. Further, a capacitive element for providing a compensation capacitance is formed in the semiconductor die. The capacitive element is coupled between the contact element and the electronic circuit. The capacitive element and the contact element are electrically coupled via an inductive element in order to form a compensation network for compensating RF parasitics. The method 1200 further comprises applying 1204 a (e.g. RF) test signal to the contact element via the RF probe.

Using the proposed LC compensation network, the method 1200 may allow to overcome RF parasitics over a wide frequency range. Accordingly, method 1200 may allow broadband RF measurement/characterization of the electronic circuit with high performance, i.e. low signal loss and signal reflections at the interface between the RF probe and the contact element.

If the capacitive element comprises a MEMS capacitor exhibiting an adjustable capacitance, the method 1200 may additionally comprise supplying 1206 one or more control signals to the MEMS capacitor for adjusting the adjustable capacitance of the MEMS capacitor (e.g. to a predefined capacitance). Accordingly, a desired target frequency range for compensating the RF parasitics may be adjusted.

More details and aspects of the method 1200 are explained in connection with the proposed technique or one or more examples described above. The method 1200 may comprise one or more additional optional features corresponding to one or more aspects of the proposed technique or one or more examples described above.

The examples as described herein may be summarized as follows:
Some examples relate to a semiconductor die. The semiconductor die comprises a contact element for coupling the semiconductor die to the exterior. The contact element is coupled to an electronic circuit formed in the semiconductor die. Further, the semiconductor die comprises a capacitive element for providing a compensation capacitance. The capacitive element is coupled between the contact element and the electronic circuit. The capacitive element and the contact element are electrically coupled via an inductive element in order to form a compensation network for compensating RF parasitics.

In some examples, the capacitive element comprises at least one pad of electrically conductive material.

According to some examples, the capacitive element comprises at least one metal-insulator-metal capacitor.

In some examples, the capacitive element comprises at least one MEMS capacitor configured to receive one or more control signals for adjusting an adjustable capacitance of the at least one MEMS capacitor.

According to some examples, the capacitive element is formed on a surface of the semiconductor die.

In alternative examples, the capacitive element is formed within the semiconductor die.

In some examples, the inductive element is a signal line coupling the capacitive element and the contact element.

According to some examples, at least one of the capacitive element and the inductive element is a multilayer element formed in multiple layers of the semiconductor die.

In some examples, a capacitance of the capacitive element and an inductance of the inductive element are selected based on one or more target frequency ranges for compensating the RF parasitics.

According to some examples, the capacitive element comprises more than one capacitive sub-element.

In some examples, the semiconductor die further comprises a second capacitive element for providing a second compensation capacitance, wherein the second capacitive element is coupled between the capacitive element and the electronic circuit, and wherein the second capacitive element is electrically coupled to the capacitive element and the contact element via a second inductive element to form the compensation network.

According to some examples, the capacitive element and the inductive element form a first section of the compensation network for compensating the RF parasitics in a first target frequency range, and wherein the second capacitive element and the second inductive element form a second section of the compensation network for compensating the RF parasitics in a second target frequency range.

In some examples, the capacitive element and the second capacitive element exhibit different capacitances and/or the inductive element and the second inductive element exhibit different inductances.

Other examples relate to a method for testing an electronic circuit formed in a semiconductor die. The method comprises placing a RF probe onto a contact element of the semiconductor die for coupling the semiconductor die to the exterior. The contact element is coupled to the electronic circuit. A capacitive element for providing a compensation capacitance is formed in the semiconductor die. The capacitive element is coupled between the contact element and the electronic circuit. The capacitive element and the contact element are electrically coupled via an inductive element in order to form a compensation network for compensating RF parasitics. The method further comprises applying a test signal to the contact element via the RF probe.

According to some examples, the capacitive element comprises at least one MEMS capacitor exhibiting an adjustable capacitance, wherein the method further comprises supplying one or more control signals to the at least one MEMS capacitor for adjusting the adjustable capacitance of the at least one MEMS capacitor.

Examples according to the proposed technique may allow die pad capacitance compensation by aid of an additional LC network.

The aspects and features mentioned and described together with one or more of the previously detailed examples and figures, may as well be combined with one or more of the other examples in order to replace a like feature of the other example or in order to additionally introduce the feature to the other example.

The description and drawings merely illustrate the principles of the disclosure. Furthermore, all examples recited herein are principally intended expressly to be only for illustrative purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

It is to be understood that the disclosure of multiple acts, processes, operations, steps or functions disclosed in the specification or claims may not be construed as to be within the specific order, unless explicitly or implicitly stated otherwise, for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or -steps, respectively. Such sub acts may be included and part of the disclosure of this single act unless explicitly excluded.

Furthermore, the following claims are hereby incorporated into the detailed description, where each claim may stand on its own as a separate example. While each claim may stand on its own as a separate example, it is to be noted that - although a dependent claim may refer in the claims to a specific combination with one or more other claims - other examples may also include a combination of the dependent claim with the subject matter of each other dependent or independent claim. Such combinations are explicitly proposed herein unless it is stated that a specific combination is not intended. Furthermore, it is intended to include also features of a claim to any other independent claim even if this claim is not directly made dependent to the independent claim.

## Claims

1. A semiconductor die (100), comprising:
a contact element (110) for coupling the semiconductor die (100) to the exterior, wherein the contact element (110) is coupled to an electronic circuit (140) formed in the semiconductor die (100); and
a capacitive element (130) for providing a compensation capacitance, wherein the capacitive element (130) is coupled between the contact element (110) and the electronic circuit (140), and wherein the capacitive element (130) and the contact element (110) are electrically coupled via an inductive element (120) in order to form a compensation network for compensating radio frequency parasitics.

2. The semiconductor die (100) of claim 1, wherein the capacitive element (130) comprises at least one pad of electrically conductive material.

3. The semiconductor die (100) of claim 1 or claim 2, wherein the capacitive element (130) comprises at least one metal-insulator-metal capacitor.

4. The semiconductor die (100) of any of claims 1 to 3, wherein the capacitive element (130) comprises at least one MEMS capacitor configured to receive one or more control signals for adjusting an adjustable capacitance of the at least one MEMS capacitor.

5. The semiconductor die (100) of any of claims 1 to 4, wherein the capacitive element (130) is formed on a surface of the semiconductor die (100).

6. The semiconductor die (100) of any of claims 1 to 4, wherein the capacitive element (130) is formed within the semiconductor die (100).

7. The semiconductor die (100) of any of claims 1 to 6, wherein the inductive element (120) is a signal line coupling the capacitive element (130) and the contact element (110).

8. The semiconductor die (100) of any of claims 1 to 7, wherein at least one of the capacitive element (130) and the inductive element (120) is a multilayer element formed in multiple layers of the semiconductor die (100).

9. The semiconductor die (100) of any of claims 1 to 8, wherein a capacitance of the capacitive element (130) and an inductance of the inductive element (120) are selected based on one or more target frequency ranges for compensating the radio frequency parasitics.

10. The semiconductor die (100) of any of claims 1 to 9, wherein the capacitive element (130) comprises more than one capacitive sub-element.

11. The semiconductor die (100) of any of claims 1 to 10, further comprising:
a second capacitive element (160) for providing a second compensation capacitance, wherein the second capacitive element (160) is coupled between the capacitive element (130) and
the electronic circuit (140), and wherein the second capacitive element (160) is electrically coupled to the capacitive element (130) and the contact element (110) via a second inductive element (150) to form the compensation network.

12. The semiconductor die (100) of claim 11, wherein the capacitive element (130) and the inductive element (120) form a first section of the compensation network for compensating the radio frequency parasitics in a first target frequency range, and wherein the second capacitive element (160) and the second inductive element (150) form a second section of the compensation network for compensating the radio frequency parasitics in a second target frequency range.

13. The semiconductor die (100) of claim 11 or claim 12, wherein the capacitive element (130) and the second capacitive element (160) exhibit different capacitances, and/or wherein the inductive element (120) and the second inductive element (150) exhibit different inductances.

14. A method (1200) for testing an electronic circuit formed in a semiconductor die, the method comprising:
placing (1202) a radio frequency probe onto a contact element of the semiconductor die for coupling the semiconductor die to the exterior, wherein the contact element is coupled to the electronic circuit, wherein a capacitive element for providing a compensation capacitance is formed in the semiconductor die, wherein the capacitive element is coupled between the contact element and the electronic circuit, and wherein the capacitive element and the contact element are electrically coupled via an inductive element in order to form a compensation network for compensating radio frequency parasitics; and
applying (1204) a test signal to the contact element via the radio frequency probe.

15. The method (1200) of claim 14, wherein the capacitive element comprises at least one MEMS capacitor exhibiting an adjustable capacitance, wherein the method further comprises supplying (1206) one or more control signals to the at least one MEMS capacitor for adjusting the adjustable capacitance of the at least one MEMS capacitor.
